# EUROPEAN PATENT SPECIFICATION

(11) **EP 1 647 560 B1**
(45) Date of publication and mention of the grant of the patent: **13.02.2008**
(21) Application number: 04447226.4
(22) Date of filing: 13.10.2004
(51) Int. Cl.: C08F 283/00, C09K 11/00, C08G 61/02, H01L 51/30

(54) **Conjugated polymers provided with at least one MIP and a method for their preparation via conjugated macro-iniferters**
Konjugierte Polymere mit zumindest einem molekular geprägten Polymer und ein Verfahren zu seiner Herstellung via konjugierte Makroiniferter
Polymères conjugues comprenant au moins un polymère conjugue à empreinte moléculaire et leur procédé de préparation via macroiniferters conjugues

(43) Date of publication of application: 19.04.2006
(73) Proprietor: INTERUNIVERSITAIR MICROELEKTRONICA CENTRUM VZW, 3001 Leuven (BE); Universiteit Hasselt, 3590 Diepenbeek (BE)
(72) Inventor: Lutsen, Laurence, 59210 Coudekerque-Branche (FR); Vanderzande, Dirk, 3500 Hasselt (BE)
(74) Representative: Bird, Ariane

(56) References cited:
- US-A- 5 817 430
- US-A1- 2003 166 306
- US-B1- 6 759 488
- HIROKI SAITO ET AL: "SYNTHESIS OF SOLUBLE POLY(ARYLENEVINYLENE)S CARRYING VARIOUS HETEROCYCLES AS ARYLENE UNITS" MACROMOLECULES, AMERICAN CHEMICAL SOCIETY. EASTON, US, vol. 28, no. 24, 20 November 1995 (1995-11-20), pages 8363-8367, XP000539439 ISSN: 0024-9297
- MAGNUS GLAD, PER REINHOLDSSON, KLAUS MOSBACH: "Molecularly imprinted composite polymers based on trimethylolpropane trimethacrylate (TRIM) particles for efficient enantiomeric separations" REACTIVE POLYMERS, vol. 25, 1995, pages 47-54, XP002320294

## Description

### Technical field of the invention

The present invention relates to conjugated polymers provided with at least one molecular imprinted polymer (MIP). More particularly, the invention relates to a method for preparing molecularly imprinted conjugated polymers by using conjugated macro-iniferters and to electronic devices comprising such molecularly imprinted conjugated polymers. The invention furthermore relates to a method for preparing a conjugated macro-iniferter.

### Background of the invention

Conjugated polymers are organic macromolecules comprising at least one backbone chain of alternating double- and single-bonds. The optoelectronic properties of conjugated (semi-conducting) polymers have created opportunities for a number of applications such as, for example, light-emitting diodes, light-emitting electrochemical cells, solid-state lasers, solar cells, photodetectors and recently biological and chemical sensors for use in medical diagnostics and toxicology.

It is essential for active layers in chemo- or bio- sensors to combine two functions, i.e. selective molecular recognition and signal transduction. Molecular imprinting polymers (MIP) have unique properties that make them especially suitable for this sensor technology. MIPs exhibit a good specificity to various compounds of medical, environmental and industrial interest and have excellent operational stability. However, because these arrangements do not fulfil the criterion that a biosensor has a recognition element and transducer in close proximity, they cannot be considered biomimetic sensors in the strict sense.

Bio-electronics is a rapidly progressing interdisciplinary research field at the junction of chemistry, biochemistry, physics and material science that aims to integrate biomolecules and electronic elements into functional systems. The passage of electrons between biomolecules and electronic elements is the essence of all bio-electronic systems. Nevertheless, electronic units and biomolecules lack natural communication. Different electronic methods have been employed to transduce the biological functions occurring at the electronic supports. These include electrical transduction, such as current, potential changes, piezoelectric transduction, field effect transistors transduction, photo-electrochemical transduction and others.

An important aspect in the design of a MIP-based sensor is to find an appropriate way of interfacing the polymer with the transducer. In most cases, the MIP has to be brought into close contact with the transducer surface. Up to now several approaches were investigated:
- In situ electro-polymerisation on conducting surfaces such as gold.
- Entrapped MIP-particles into gels and behind a membrane for use with electrochemical transducers.
- Spin-coated suspension of MIP particles in solution of inert PVC polymer.
- Composite particles consisting of an electrically grown conducting polypyrrole into a preformed porous MIP.

Up to now grafting of molecularly imprinted polymers or MIPs were reported as grafted coatings on various porous or non-porous surface supports, inorganic materials as oxide or silica particles, on organic materials as resins, i.e. non-conducting materials.

WO 01/19886 provides a material that consists in a support coated with a polymer and a method for forming it. The material is prepared by grafting a polymer layer on the surface of a performed organic or inorganic support material or surface. The grafting can be combined with the technique of molecular imprinting. A molecularly imprinted polymer can be obtained by polymerising a composition comprising at least one monomer, and a template on a support in a polymerisation medium with a free radical initiator, whereafter the templates is removed from the resultant polymer. The polymerisation is confined on the surface of the support. The support used in the present invention is preferably selected from the group consisting of porous and non-porous, planar and non-planar inorganic and organic supports. As examples of such support materials may be mentioned oxides such as alumina and silica, and organic resins.

The main drawback of MIPs for use in sensors is the fact that they do not have transducer properties. Hence, they can not convert biological signals into optical or electrical signals, which is a key features for sensors which are to be used in, for example, molecular diagnostics, biological or chemical sample analysis.

### Summary of the invention

It is an object of the present invention to provide an alternative polymer material with a wider range of properties as well as methods of making the material and devices comprising the material.

The above objective is accomplished by a method and device according to the present invention.

In one aspect the present invention provides a single polymer material which combines both transducer properties and selectivity properties, as well as a method for preparing such a material. For example, the present invention provides a novel polymer molecule or polymer material which is called molecularly imprinted conjugated polymer or MICP. The molecularly imprinted conjugated polymer according to the invention has both a transducer functionality and selectivity functionality. The MICP can comprise a conjugated polymer backbone and at least one molecularly imprinted polymer or MIP grafted on the conjugated polymer backbone.

A conjugate polymer need not be fully, i.e. 100%, conjugated because there can always be structural defects which can lead, depending on the synthesis method used, to about 2 to 8%, in most cases between 2 to 5% of the resulting polymer that has not been conjugated. Therefore, in accordance with the present invention a reference to conjugated polymer includes within its scope a deviation from complete conjugation of about 2 to 5%.

An advantage of the conjugated polymer provided with at least one molecularly imprinted polymer according to the invention is that is combines two functions, i.e. selectivity and transducer properties, in one single material. Therefore, the MICP according to the invention is particularly suited for use in bio- or chemosensors. Furthermore, the conjugated polymer according to the invention may be used in other electronic devices, such as for example, organic field effect transistors, bilayer heterojunctions organic solar cells, hybrid organic solar cells, bulk heterojunctions organic solar cells and all kind of plastic electronic devices. Furthermore, the molecularly imprinted conjugated polymers according to the invention may be used in chromatography, in molecular recognition, in selective sample enrichment or in catalysis.

The molecularly imprinted polymers grafted on the conjugated polymer backbone comprise cavities which may be formed by using template molecules during the formation reaction of the molecularly imprinted conjugated polymers. A cavity may be defined as a free volume within the polymer matrix having a specific shape, size and functional groups, determined by the kind of template molecule used during the polymerisation reaction.

In embodiments according to the invention, the molecularly imprinted conjugated polymer may be based on poly(p-phenylene vinylene) derivatives, polymers and copolymers, such as for example MDMO-PPV or OC1 C10-PPV, on polythiophene derivatives, polymers or copolymer derivatives, such as for example P3HT, or on any other suitable conjugated polymer.

The present invention furthermore provides a method for the formation of a molecularly imprinted conjugated polymer or, in other words, for the formation of a conjugated polymer provided with at least one molecularly imprinted polymer. The method comprises:
- forming a partially converted conjugated polymer, which forms a conjugated macro-iniferter polymer, and
- providing a first molecularly imprinted polymer or MIP onto the conjugated macro-iniferter polymer.

Forming a partially converted conjugated polymer which is a conjugated macro-iniferter may be performed in solution or in thin film and may comprise:
- reacting a solution of monomers with a basic compound to form a precursor polymer, and
- partially converting the precursor polymer.

Providing a first molecularly imprinted polymer or MIP onto the conjugated macro-iniferter polymer may comprise:
- irradiating the conjugated macro-iniferter polymer with UV light, thus forming a conjugated macro-iniferter radical, and
- reacting the macro-iniferter radical with at least a first and a second monomer in the presence of a template molecule.

In a preferred embodiment according to the invention, the providing or grafting of a first molecularly imprinted polymer or MIP onto the conjugated macro-iniferter polymer may furthermore comprise removing the template molecule, hereby forming cavities. This may be done by for example performing a washing step with an organic or aqueous solvent or with a mixture of at least two solvents.

In an embodiment according to the invention, the method may furthermore comprise providing a second molecularly imprinted polymer onto the partially converted polymer.

In a further aspect of the invention, the molecularly imprinted conjugated polymer according to the invention may be used in bio- or chemosensors, in electronic devices, such as for example, organic field effect transistors, bilayer heterojunctions organic solar cells, hybrid organic solar cells, bulk heterojunctions organic solar cells and all kind of plastic electronic devices. Furthermore, the molecularly imprinted conjugated polymers according to the invention may be used in chromatography, in molecular recognition, in selective sample enrichment or in catalysis.

Although there has been constant improvement, change and evolution of devices in this field, the present concepts are believed to represent substantial new and novel improvements, including departures from prior practices, resulting in the provision of more efficient, stable and reliable devices of this nature.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 illustrates a reaction scheme of the dithiocarbamate precursor route according to an embodiment of the present invention for the synthesis of a partially conjugated polymer used as conjugated macro-iniferter.
Fig. 2 illustrates the use of a conjugated macro-iniferter for the synthesis of a molecular imprinted conjugated polymer in accordance with an embodiment of the present invention.
Fig. 3 illustrates a reaction scheme for a molecular imprinted conjugated polymer synthesised as bulk material in accordance with an embodiment of the present invention.
Fig. 4 illustrates a reaction scheme of a molecular imprinted conjugated polymer synthesized using a thin film macro-iniferter polymer in accordance with an embodiment of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

The invention provides a novel material comprising a conjugated polymer as a backbone with provided thereon at least one MIP. In the further description, the novel material according to the present invention will be referred to as "molecularly imprinted conjugated polymer" or MICP. Molecularly imprinted conjugated polymers (MICPs) are a new concept of molecularly imprinted polymers or MIPs in which the function of transducer is introduced by incorporating a conjugated polymer backbone onto which a MIP can be grafted. Strictly spoken, a conjugate polymer is never fully (for 100%) conjugated because there are always structural defects which can lead, depending on the synthesis method used, to about 1 to 5% of chemical defects which may break through the conjugation of the polymer, and hence to about 1 to 5% of the resulting polymer may not be conjugated. Therefore, when, in the further description, is talked about conjugated polymers, it has to be noted that this deviation of about 1 to 5% has been taken into account.

The molecularly imprinted conjugated polymer or MICP according to the present invention combines two functions, i.e. molecular recognition and signal transducer, in one single material. This is contrary to the molecularly imprinted polymers or MIPs which only have a selectivity function. The invention furthermore provides a method for the fabrication of such a molecularly imprinted conjugated polymer and the use of this material in, for example, chemo- or bio- sensors, in all kind of electronic devices, in chromatography, in molecular recognition, in selective sample enrichment and in catalysis as well as the devise made with the material.

Conjugated polymers with macromolecular side chains that are molecularly imprinted polymers will place the transducer (conjugated backbone) very close to the recognition element (molecularly imprinted polymer). Hence, molecularly imprinted conjugated polymers are a new class of materials, exhibiting predetermined selective molecular recognition in combination with electrical conductivity, and fluorescence properties.

The invention provides a molecular imprinted conjugated polymer or MICP and a method for preparing such a molecular imprinted conjugated polymer. The molecular imprinted conjugated polymer according to the invention is prepared by reacting at least one functional monomer, a cross linking monomer, a template, and a conjugated macro-iniferter polymer under polymerising conditions, optionally followed by removing the template from the resultant polymer.

In a first reaction step, a monomer comprising an initiator group such as e.g. a dithiocarbamate groupor any other suitable initiator group, is reacted with a basic compound in the presence of an organic solvent (or aqueous solvent or mixture of two solvents) to obtain a precursor polymer, which, in a further step of the reaction, will be converted into the corresponding partially conjugated polymer. In the further description, the method according to the present invention will be described starting from dithiocarbamate functionalized monomers. However, it has to be understood that this is only by means of an example and is not limiting to the invention.

In a preferred embodiment of the invention, the monomer may be a dithiocarbamate functionalized monomer with general formula 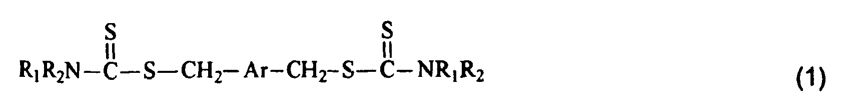 wherein Ar is an aromatic group or a heteroaromatic group with or without side groups or side chains, with or without extended aromatic systems, with or without electronic charges, with or without cyclic structures, etc. and all copolymers of two or more different monomers. As already described, the invention may also be applied in case of monomers in which the dithiocarbamate group is replaced by any other suitable functional group which may have the function of a radical initiator group.

According to an embodiment of the invention, the Ar group may be an aromatic divalent group with any of 4 to 20 carbon atoms which may be substituted with one or more substituents independently selected from the group consisting of C₁-C₂₀-alkyl, C₃-C₂₀-alkoxy or C₁-C₂₀-alkylsulfate. These groups may comprise up to 4 heteroatoms chosen from the group comprising oxygen, sulphur, and nitrogen in the aromatic divalent group.

In a further embodiment, the aromatic or heteroaromatic divalent group may be selected from the group consisting of 1,4-phenylene; 2,6-naphthalenediyl; 1,4-naphthalenediyl; 1,4-anthracenediyl; 2,6-anthracenediyl; 9,10-anthracenediyl; 2,5-thienylene; 2,5-furanediyl; 2,5-pyrrolediyl; 1,3,4-oxadiazole-2,5-dyil; 1,3,4-thiadiazole-2,5-diyl; 2,5-benzo[c]thienylene; thieno[3,2-b]thiophene-2,5-diyl; pyrrolo[3,2-b]pyrrole-2,5-diyl; pyrene-2,7-diyl; 4,5,9,10-tetrahydropyrene-2,7-diyl; 4,4'-bi-phenylene; phenantrene-2,7-diyl; 9,10-dihydrophenantrene-2,7-diyl; dibenzofurane-2,7-diyl; dibenzothiophene-2,7-diyl, fluoranthenediyl. Preferably, Ar is 1,4-phenylene or 2,5-thienylene and most preferably Ar is 2,5-thienylene.

In embodiments according to the invention, R₁ and R₂ may be a C₁-C₂₀₋alkyl group. In other embodiments, R₁ and R₂ may be selected from the group consisting of methyl, ethyl and isopropyl. R₁ and R₂ may, in some embodiments, be different from each other, but may however, in other embodiments, also be the same.

The basic compound may be a metal base, an ammonium base or a non-charged base such as amines like for example triethylamine, pyridine and non-ionic phosphazene bases. The metal in this basic compounds may preferably be an alkaly metal or an alkaly earth metal, i.e. a metal from group I or II. Classes of metal and ammonium bases are metal hydrides, such as NaH or KH, metal hydroxides, such as NaOH, LiOH or KOH, metal alkoxides, such as NaOMe or NaOEt, KOtBu, metal amides, such as NaNH₂, NaN(SiMe₃)₂, lithiumdiisopropylamide (LDA), organometal compounds wherein the metal is an alkaly metal or alkaly earth metal, such as for example a C₁₋₂₀ alkyl lithium (e.g. n-BuLi) or a C₁₋₂₀ alkyl sodium, Grignard reagents, and ammonium hydroxides. When polar aprotic solvents are used as an organic solvent, it is preferred to use metal hydrides as they show substantially no nucleophilic properties. In polar protic solvents it is preferred to use bases with a pKa larger than the pKa of the solvent. In this case the solvent is deprotonated and acts as the actual basic compound. In the method of the present invention, it may be preferred to use an aprotic solvent. A mixture of solvents may also be used. Examples of solvents which may be used are for example amides of the general formula R₃-CONR₄H, amines of the general formula R₅R₅-N-R₆, sulfones of the general formula R₆-SO₂-R₇, sulfoxides of the general formula R₆-SO-R₇, a solvent from the group consisting of alcohols, such as for example sec-butanol and all linear or branched CₙH₂ₙ₊₂O where 1 ≤ n ≤ 20, glycols, polyethers, cyclic ethers, unsaturated ethers, wherein R₃, R₄ are the same or different and denote H, a linear or branched alkyl group, or R₃ and R₄ together are -(CH₂)₂-, -(CH₂)₃-, CH₂-CH=CH₂-CH₂ or -(CH₂)₄-; and R₅ has the meaning of R₃ or is a phenyl group which is unsubstituted or substituted by halogen, methyl and/or methoxy groups; and R₆, R₇ are the same or different and have the meaning of R₅, except H, or R₆ and R₇ together are -(CH₂)₂-, -(CH₂)₃-, -(CH₂)₄- or -CH₂-CH=CH-CH₂-.

In a second reaction step the precursor polymer is converted into the corresponding partially converted conjugated polymer. By 'partially converted' is meant that in the conjugated polymer, formed by converting the precursor polymer formed after reaction of the starting monomer comprising initiator groups, such as for example dithiocarbamate groups, with a basic compound, not all initiator groups, such as for example dithiocarbamate groups, are eliminated and hence, still some remaining initiator groups, such as for example dithiocarbamate groups, are present in the resulting conjugated polymer, thus called partially converted conjugated polymer.

The precursor polymer may be converted into the corresponding partially conjugated polymer in two ways, i.e. by thermal heating of the precursor polymer solution under inert atmosphere or in thin film prepared by spin-coating or drop-casting under vacuum or under inert atmosphere. The remaining initiator groups, such as in the example given, dithiocarbamate groups, are randomly distributed over the conjugated polymer and their exact position can not be controlled. The percentage of remaining initiator groups, such as in the example given dithiocarbamate groups, within the conjugated polymer may be tuned by changing the experimental conditions such as, for example, temperature, conversion time, atmosphere. The amount of remaining initiator groups, such as in the example given dithiocarbamate groups, may, according to the invention, preferably be less than 10%, more preferably less than 5% and most preferably less than 1 %. For example, if the percentage of the remaining initiator groups is 5%, it means that there are, in the resulting partially converted conjugated polymer, for 100 monomer units 5 monomer units still having an initiator group and 95 monomer units not having an initiator group. The lower the amount of remaining dithiocarbamate groups, the higher the conjugation degree of the conjugated polymer backbone, and hence, the better the transducer properties of the resulting MICP.

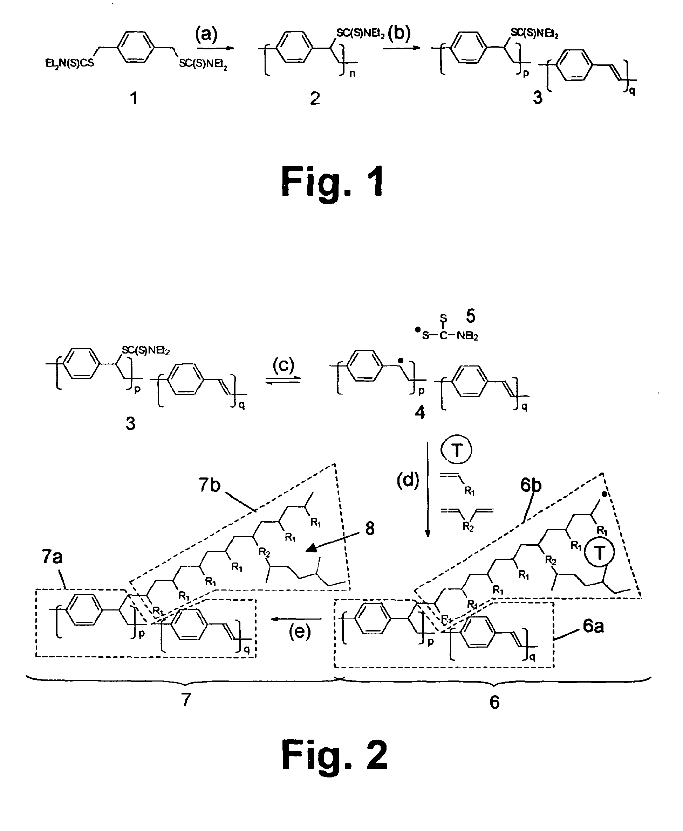

In Fig. 1, the reaction mechanism for forming a partially converted conjugated polymer starting from a dithiocarbamate monomer, this reaction mechanism also called dithiocarbamate precursor route and described in patent application with application n° EP 03 447 264 (not yet published), is illustrated. In the example given, a starting dithiocarbamate monomer 1 with general formula (1), wherein the Ar group is a benzene ring and wherein R₁ = R₂ = an ethyl group (Et), is, in a first reaction step (a), reacted with a strong base to form the corresponding precursor polymer 2. In a next reaction step (b), the precursor polymer 2 is converted into the corresponding partially converted conjugated polymer 3, for example, by thermal heating of a precursor polymer solution. As can be seen from Fig. 1, the partially converted conjugated polymer 3 still comprises some remaining dithiocarbamate groups, in the example given SC(S)NEt₂, on the conjugated backbone.

After forming the partially converted conjugated polymer, this partially converted conjugated polymer, also called conjugated macro-iniferter polymer, is irradiated with UV for a certain time, for example for 70 min, which is preferably not higher than 3 hours. UV irradiation may, for example, be performed by means of a mercury UV lamp. The wavelength of the UV light is hereby not of importance, the fully wavelength range of the UV light can be used and may be tuned in accordance with the maximum absorption of the partially converted polymer.. Due to the UV irradiation, radicals are formed, i.e. a first radical is formed at the place where a remaining initiator group, such as e.g. a dithiocarbamate group, was positioned thus forming a conjugated macro-iniferter radical, and a second radical is an initiator group radical, such as e.g. a dithiocarbamate radical. It has to be noted that from the moment the UV irradiation is stopped, the radicals get back together to form the partially converted conjugated polymer. The method for forming partially converted conjugated polymers via the above described method, allows the preparation of conjugated macro-iniferters which can promote controlled radical polymerization under UV irradiation and which can be used for the preparation of molecularly imprinting polymers (MIPs) grafted on semi-conducting conjugated polymers.

It has furthermore to be noted that other methods for forming radicals may also be used according to the present invention, such as e.g. radical formation via heating. However, in that case the starting monomers should comprise initiator groups which form radicals by heating. This is not the case when dithiocarbamate groups are used as initiator groups.

The conjugated macro-iniferter radical is then reacted with at least a first functional monomer, for example a vinylate, acrylate or methacrylate monomer, and a second functional monomer, for example a vinylate, arylate or methacrylate monomer, and in the presence of a template molecule. One of these functional monomers may have the function of a cross linking monomer. The template molecule may be an organic or inorganic molecule, antibodies, antigens, amino acids, peptides, proteins, ions, nucleotides or derivatives thereof. This reaction step (d) results in a polymer being grafted onto the conjugated polymer backbone at that position of the conjugated macro-iniferter where the radical was positioned. This results in a molecularly imprinted conjugated polymer comprising a cavity to which the template molecule is still bound. A cavity may be defined as a free volume within the polymer matrix having a specific shape and size, determined by the kind of template used during the polymerisation reaction. Preferably, the template molecule may then be removed by performing a washing step using, for example, an organic or an aqueous solvent or a mixture of at least two solvents.

The resulting molecularly imprinted conjugated polymer may have an average molecular weight of between 40 kD and 1000 kD, preferably between 40 kD and 300 kD. The ratio between the conjugated polymer backbone and the MIP may be 50/50. The molecular weight of the MICP may be controlled by the degree of polymerisation such that the molecules does not become too big, i.e. does not become higher than 1000 kD, preferably not higher than 300 kD. Too high molecular weights may result in molecules wherein the cavity 8 in the MIP is not close enough to the conjugate polymer backbone, which may be a drawback when the MICPs are used in, for example, sensors.

The above described reaction mechanism, called free radical polymerization, is illustrated in Fig. 2, starting from the partially converted conjugated polymer 3, based on the dithiocarbamate monomer, as formed in Fig. 1. In reaction step (c), the partially converted conjugated polymer 3, also called partially conjugated macro-iniferter, with a benzene ring as the aryl group and with R₁ = R₂ = Et, is irradiated with UV light leading to formation of a conjugated macro-iniferter radical 4 and a dithiocarbamate radical 5. Next, (step (d)) the conjugated macro-iniferter radical 4 is reacted with a template molecule T and with, in this specific example, acrylate and vinylate monomers. This leads to a polymer 6, which is a conjugated polymer grafted with a molecularly imprinted polymer or MIP. This polymer 6 still comprises the template molecule T. By washing polymer 6 in a washing step (e), the template molecule T may be removed, hereby forming a molecularly imprinted conjugated polymer 7 comprising a conjugated polymer backbone 7a and grafted thereon a MIP 7b comprising cavities 8. The remaining radicals in polymer 6 will be quenched in the work-up phaseDuring the washing step (step e), if still some remaining radical(s) are present in polymer 6, there will be then quenched.

According to some embodiments of the invention, the free radical polymerization reaction as described in steps (d) and (e), may be repeated at least once with a different composition of the solution, i.e. with different monomers and different templates T, in order to obtain a molecular imprinted conjugated co-polymer with at least one further property of selectivity. Hence, a material can be obtained which shows selectivity properties for at least two different molecules and transducer properties.

It has already been described that the conversion step (b) may be performed in solution and in thin film. When, in one embodiment, the conversion step (b) is performed in solution the molecular imprinted conjugated polymer 7 is formed as a bulk material. The conversion in solution is only possible when the conjugated polymer is a soluble polymer. The precursor polymer 2 may be subjected to a thermal conversion step at a temperature of, for example, between 30°C and 300°C. The conversion reaction of the precursor polymer 2 starts around 100°C and may be ended at temperatures of lower than 250-300°C depending on the chemical structure of the polymer. At temperatures of about 250-300°C and higher, the precursor polymer 2 will be completely converted and there will be no remaining dithiocarbamate groups 5 left. In that case, the reaction according to the present invention for forming a molecularly imprinted conjugated polymer could not be completed.

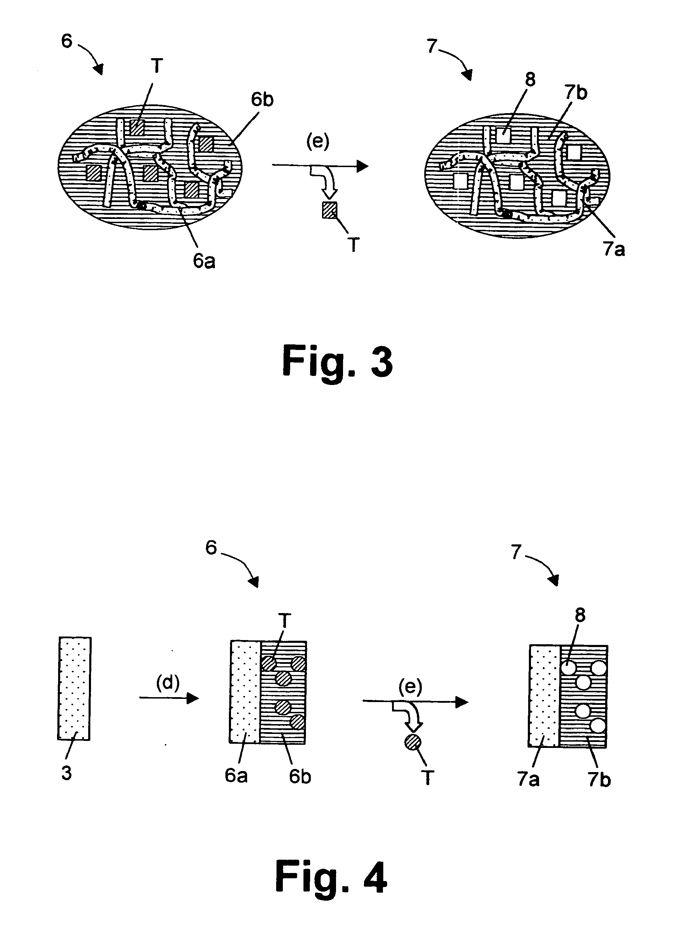

In this embodiment, the precursor polymer 2 may thus be dissolved in a solvent in a giving concentration, typically 0.1 M, and is degassed by passing through a continuous nitrogen flow for, for example, 1 hour. The temperature may then be increased and the inert atmosphere is maintained during the conversion reaction and the cooling down. The reaction can then be completed by irradiating the partly converted conjugated polymer 3, also called macro-iniferter polymer for initiating a macro-iniferter polymer radical 4 and an initiator group radical 5 which is then reacted with first and second monomers in the presence of template molecules T to form a conjugated polymer 6a grafted with a molecular imprinted polymer or MIP 6b, the MIP still comprising template molecules T. Fig. 3 illustrates the last step of the reaction mechanism, i.e. the washing step (e) for removal of the template molecules T, hereby forming a matrix of molecularly imprinted conjugated polymers 7, comprising a conjugated polymer 7a and grafted thereon a MIP 7b with cavities 8, the size and specific shape of the cavity being determined by the template molecule t used during the polymerisation reaction.

In another embodiment, the conversion step (b) may be performed in thin film. Herefore, glass substrates coated with indium tin oxide (ITO) are cleaned with isopropanol in an ultrasonic bath for 20 minutes and dried in nitrogen flow. The active layer may then be spin-coated on the glass substrate from a solution of the precursor polymer 2. A two-step process may be used. A first step determines the film thickness and may be done with a closed cover for, for example, 5 seconds at 600 rpm. In a second step the film may be dried with an open cover for, for example, 2 minutes at 40 rpm. The conversion of the precursor polymer 2 in film may be done in a glove box under inert atmosphere on a hot plate from room temperature to the conversion temperature at 2°C/min followed by less than 10 minutes at the conversion temperature, in order to obtain a partly converted conjugated polymer 3, which then is used as a conjugated macro-iniferter polymer. The conversion reaction may be carried out also under vacuum conditions. After UV radiation, a conjugated macro-iniferter polymer radical 4 in thin film form may be obtained. This is illustrated in Fig. 4. The conjugated macro-iniferter polymer radical 4 is then reacted in reaction step (d) with first and second monomers in the presence of template molecules T. In that way, a conjugated polymer 6a grafted with a MIP 6b is formed, the MIP 6b still comprising the template molecules T. In this embodiment, the MIP 6b is formed as a thin film on top of the conjugated polymer 6a. After performing a washing step (e), the molecularly imprinted conjugated polymer 7 may be obtained, comprising a thin film MIP 7b with free cavities 8 on top of the conjugated polymer 7a.

The molecularly imprinted conjugated polymer 7 thus obtained comprises two parts, i.e. a conjugated polymer 7a and grafted thereon a MIP 7b, the MIP 7b comprising free cavities 8. These cavities 8 have a specific shape and size and specific functionalities, the shape, size and functionalities being determined by the template molecules T that have been used during formation of the molecularly imprinted conjugated polymer 7.

Because of its structure, the molecularly imprinted conjugated polymer 7 according to the invention may be used in chemo- and biosensors, because of the fact that it gathers two functions, i.e. the function of molecular recognition and the function of signal transducer, in one single material. Molecular recognition is achieved by the grafted molecular imprinted polymer (MIP macro-side chains), showing high selectivity determined by the cavities 8 and thus by the kind of template molecules T used for the formation of the molecularly imprinted conjugated polymers 7. Signal transducing properties are achieved by the electrical conductivity and fluorescence properties of the conjugated polymer backbone 7b. When using molecularly imprinted conjugated polymers 7 according to the invention in sensors, the use of an external transducer for converting biological signals into electrical or optical signals is no longer required. This saves production costs in the manufacturing of chemo- and biosensors. Furthermore, if no external transducers have to be added to the sensors, the sensor size can be kept small.

The molecularly imprinted conjugated polymers 7 according to the invention may furthermore also be used in other electronic devices, such as for example, but not limited to, organic field effect transistors, bilayer heterojunctions organic solar cells, hybrid organic solar cells, bulk heterojunctions organic solar cells and all kind of plastic electronic devices. Furthermore, the molecularly imprinted conjugated polymers 7 according to the invention may be used in chromatography, in molecular recognition, in selective sample enrichment or in catalysis.

Hereinafter, some specific examples, according to the method according to the invention, will be described. It has to be noted that these examples are only for illustration and are thus not limiting to the invention.

### Example 1: Synthesis of a conjugated macro-iniferter based on poly(p-phenylene vinylene).

A solution of the monomer p-xylene bis(N,N-diethyldithiocarbamate) (500 mg, 1.25 mmol) in dry THF (6.25 ml, 0.2 M) at -78°C is degassed for 1 hour by passing through a continuous nitrogen flow. An equimolar LDA solution (625 µl of a 2 M solution in THF/n-heptane) is added in one go to the stirred monomer solution. The THF/n-heptane from the basic solution is neglected in the calculation of the monomer concentration. The mixture is then kept at -78°C for 90 minutes and the passing of nitrogen is continued. After this, ethanol (6 ml) is added at -78°C to stop the reaction. The polymer is then precipitated in ice water (100 ml) and extracted with chloroform (3 x 60 ml). The solvent of the combined organic layers is evaporated under reduced pressure and a second precipitation is performed in a 1/1 mixture (100 ml) of diethyl ether and hexane at 0°C. The polymer is collected and dried in vacuum. Then, the polymer (90 mg) is dissolved in a solvent as chlorobenzene (10 ml) and is heated at 125°C for two hours. After this, the chlorobenzene is evaporated and the polymer is precipitated in methanol at 0°C. The macro-iniferter polymer is collected and dried in vacuum. This allows the manufacturing of a conjugated macro-iniferter polymer. The quantity of remaining dithiocarbamate groups and conjugation may be tuned by experimental conditions, which can be different from what is described here in this specific example.

### Example 2: Synthesis of a conjugated macro-inifeter based on OC1C10-PPV.

A solution of 2,5-bis(*N*,*N*-diethyl dithiocarbamate)-1-(3,7-dimethyl octyloxy)-4-methoxybenzene (250 mg, 0.42662 mmol) in dry THF (2.13 ml, 0.2 M) at room temperature is degassed for 1 hour by passing through a continuous nitrogen flow. An equimolar LDA solution (213 µL of a 2 M solution in THF/*n*-heptane) is added in one go to the stirred monomer solution. The THF/n-heptane from the basic solution is neglected in the calculation of the monomer concentration. The mixture is then kept at room temperature for 90 minutes and the passing of nitrogen is continued. The polymer is precipitated in ice water (100 ml) and extracted with chloroform (3 x 60 ml). The solvent of the combined organic layers was evaporated under reduced pressure and a second precipitation is performed in 100 ml of methanol at 0°C. The polymer is collected and dried in vacuum. Yield: 69%, M_{w} (DMF) = 18400, PD = 3.3.

The precursor polymer (90 mg) is then dissolved in chlorobenzene (10 ml) and heated at 125°C for two hours. After this, the chlorobenzene is evaporated and the polymer is precipitated in methanol at 0°C. The polymer is collected and dried in vacuum. Yield: 80%, M_{w} (DMF) = 13300, PD = 2.2. This allows the manufacturing of a conjugated macro-iniferter polymer based on the OC1 C10-PPV chemical structure. The quantity of remaining dithiocarbamate groups and conjugation are tuned by experimental conditions, which can be different from what is described here in that example.

### Example 3: Synthesis of a conjugated polymer grafted with long organic side chains that are also polymers (not conjugated).

A conjugated macro-iniferter polymer (10 mg), for example as prepared in example 1 or 2, is brought into a quartz flask and 2.2 ml of distilled methyl methacrylate (MMA) is added. The solution is degassed by three freeze-pump-thaw cycles. The polymerisation was initiated by irradiation with an ultrahigh pressure mercury UV lamp for 70 minutes at room temperature under nitrogen atmosphere. The distance of the lamp to the flask is about 3 cm. After this, the polymer is precipitated in methanol at 0°C, collected and dried in vacuum. This allows the manufacturing of a bulk material that is a conjugated polymer grafted with macro-side chains, which are here in that example PMMA polymer chains. GPC results (THF as solvent, polystyrene standards): M_{w} = 152 200, PD = 2.2. Other monomers can be used in the same method.

### Example 4: Synthesis of a molecularly imprinted conjugated polymer

The conjugated macro-iniferter polymer as, for example, prepared according to example 1 or 2, is brought into a quartz flask, distilled monomer for example methyl methacrylate (MMA), a cross-linkar monomer for example Ethylene glycol dimethacrylate (EGDMA) and a template molecule, for example D- or L-phenylalanine anilide is added. The solution is degassed by three freeze-pump-thaw cycles. The polymerisation was initiated by irradiation with an ultrahigh pressure mercury UV lamp for a given time at room temperature under nitrogen atmosphere. The distance of the lamp to the flask is about 3 cm. After this, the polymer is precipitated in methanol at 0°C, collected and dried in vacuum. The polymer is then washed with a suitable solvent to eliminate the template molecule. This allows the manufacturing of a bulk material that is a molecularly imprinted conjugated polymer. Other monomers and other template molecules can be chosen.

It is to be understood that although preferred embodiments, specific constructions and configurations, as well as materials, have been discussed herein for devices according to the present invention, various changes or modifications in form and detail may be made without departing from the scope and spirit of this invention.

## Claims

1. A molecularly imprinted conjugated polymer (MICP) (7) comprising:
- a conjugated polymer backbone (7a) and
- at least one molecularly imprinted polymer (7b) grafted on said conjugated polymer backbone (7a).

2. A molecularly imprinted conjugated polymer (MICP) (7) according to claim 1 having a selectivity and a transducer functionality.

3. A molecularly imprinted conjugated polymer (MICP (7) according to claim 1 or 2, the molecularly imprinted polymer comprising cavities (8), wherein said cavities (8) have a shape, size, and functional groups dependent on a template molecule (T) used during the polymerisation reaction for forming the molecularly imprinted conjugated polymer (MICP) (7).

4. A molecularly imprinted conjugated polymer (MICP) (7) according to any of the previous claims, wherein said molecularly imprinted conjugated polymer (MICP) (7) is based on poly(p-phenylene vinylene) derivatives.

5. A molecularly imprinted conjugated polymer (MICP) (7) according to any of claims 1 to 4, wherein said molecularly imprinted conjugated polymer (MICP) (7) is based on OC1C10-PPV.

6. A molecularly imprinted conjugated polymer (MICP) (7) according to any of claims 1 to 5, wherein said molecularly imprinted conjugated polymer (MICP) (7) is based on conjugated polymers which may contain one or more thiophene or fluorene units, and/or may contain arylene, heteroarylene, vinylene units.

7. A method for preparing a molecularly imprinted conjugated polymer (MICP) (7), the method comprising:
- forming a partially converted conjugated polymer (3), which is a conjugated macro-iniferter polymer, and
- grafting a first molecularly imprinted polymer (7b) onto said conjugated macro-iniferter polymer(3).

8. A method according to claim 7, wherein forming a partially converted conjugated polymer (3) which is a conjugated macro-iniferter polymer is performed in solution.

9. A method according to claim 7, wherein forming a partially converted conjugated polymer (3) which is a conjugated macro-iniferter polymer is performed in thin film.

10. A method according to any of claims 7 to 9 wherein forming a partially converted conjugated polymer (3) which is a conjugated macro-iniferter polymer comprises:
- reacting a solution of monomers (1) with a basic compound to form a precursor polymer (2), and
- partially converting said precursor polymer (2).

11. A method according to any of claims 7 to 10, wherein grafting a first molecularly imprinted polymer (7b) onto said partially converted conjugated polymer (3), which is a conjugated macro-iniferter polymer, comprises:
- irradiating said partially converted conjugated polymer (3), which is a conjugated macro-iniferter polymer, with UV light, thus forming a conjugated macroiniferter radical (4), and
- reacting said conjugated macro-iniferter radical (4) with at least a first and a second monomer in the presence of a template molecule (T).

12. A method according to claim 11, the method furthermore comprising:
- removing said template molecule (T).

13. A method according to claim 12, wherein removing said template molecule (T) is performed by performing a washing step.

14. A method according to any of claims 7 to 13, furthermore comprising:
- grafting a second molecularly imprinted polymer onto said partially converted conjugated polymer (3).

15. The use of a molecularly imprinted conjugated polymer (MICP) (7) as claimed in any of claims 1 to 6 in chemo- and biosensors.

16. The use of a molecularly imprinted conjugated polymer (MICP) (7) as claimed in any of claims 1 to 6 in electronic devices.

17. The use of a molecularly imprinted conjugated polymer (MICP) (7) as claimed in any of claims 1 to 6 in chromatography, in molecular recognition, in selective sample enrichment or in catalysis.

18. A chemo- or biosensor comprising a molecularly imprinted conjugated polymer (MICP) (7) as claimed in any of claims 1 to 6.

19. An electronic device comprising a molecularly imprinted conjugated polymer (MICP) (7) as claimed in any of claims 1 to 6.

## Patentansprüche

1. Molekular geprägtes konjugiertes Polymer (MICP) (7), umfassend:
- ein konjugiertes Polymergrundgerüst (7a) und
- mindestens ein auf das konjugierte Polymergrundgerüst (7a) aufgepfropfte molekular geprägtes Polymer (7b).

2. Molekular geprägtes konjugiertes Polymer (MICP) (7) gemäß Anspruch 1 mit einer Selektivitäts- und einer Überträgerfunktionalität.

3. Molekular geprägtes konjugiertes Polymer (MICP) (7) gemäß Anspruch 1 oder 2, wobei das molekular geprägte Polymer Hohlräume (8) umfasst, wobei die Hohlräume (8) eine Gestalt, Größe und funktionelle Gruppen aufweisen, die von einem Templatmolekül (T) abhängig sind, das während der Polymerisationsreaktion zur Bildung des molekular geprägten konjugierten Polymers (MICP) (7) verwendet wird.

4. Molekular geprägtes konjugiertes Polymer (MICP) (7) gemäß einem beliebigen der vorstehenden Ansprüche, wobei das molekular geprägte konjugierte Polymer (MICP) (7) auf Poly(p-phenylenvinylen)-Derivaten basiert.

5. Molekular geprägtes konjugiertes Polymer (MICP) (7) gemäß einem beliebigen der Ansprüche 1 bis 4, wobei das molekular geprägte konjugierte Polymer (MICP) (7) auf OC1C10-PPV basiert.

6. Molekular geprägtes konjugiertes Polymer (MICP) (7) gemäß einem beliebigen der Ansprüche 1 bis 5, wobei das molekular geprägte konjugierte Polymer (MICP) (7) auf konjugierten Polymeren basiert, die eine oder mehrere Thiophen- oder Fluoreneinheiten enthalten können und/oder Arylen-, Hereroarylen-, Vinyleneinheiten enthalten können.

7. Ein Verfahren zur Herstellung eines molekular geprägten konjugierten Polymers (MICP) (7), wobei das Verfahren umfasst:
- Bilden eines teilweise umgewandelten konjugierten Polymers (3), das ein konjugiertes Makroiniferterpolymer ist, und
- Pfropfen eines ersten molekular geprägten Polymers (7b) auf das konjugierte Makroiniferterpolymer (3).

8. Verfahren nach Anspruch 7, wobei das Bilden eines teilweise umgewandelten konjugierten Polymers (3), das ein konjugiertes Makroiniferterpolymer ist, in Lösung durchgeführt wird.

9. Verfahren nach Anspruch 7, wobei das Bilden eines teilweise umgewandelten konjugierten Polymers (3), das ein konjugiertes Makroiniferterpolymer ist, in Dünnschicht durchgeführt wird.

10. Verfahren nach einem beliebigen der Ansprüche 7 bis 9, wobei das Bilden eines teilweise umgewandelten konjugierten Polymers (3), das ein konjugiertes Makroiniferterpolymer ist, umfasst:
- Umsetzen einer Lösung von Monomeren (1) mit einer basischen Verbindung zum Bilden eines Vorläuferpolymers (2), und
- teilweise Umwandeln des Vorläuferpolymers (2).

11. Verfahren nach einem beliebigen der Ansprüche 7 bis 10, wobei das Pfropfen eines ersten molekular geprägten Polymers (7b) auf das teilweise umgewandelte konjugierte Polymer (3), das ein konjugiertes Makroiniferterpolymer ist, umfasst:
- Bestrahlen des teilweise umgewandelten konjugierten Polymers (3), das ein konjugiertes Makroiniferterpolymer ist, mit UV-Licht, wodurch ein konjugiertes Makroiniferterradikal (4) gebildet wird, und
- Umsetzen des konjugierten Makroiniferterradikals (4) mit mindestens einem ersten und einem zweiten Monomer in Gegenwart eines Templatmoleküls (T).

12. Verfahren nach Anspruch 11, wobei das Verfahren ferner umfasst:
- Entfernen des Templatmoleküls (T).

13. Verfahren nach Anspruch 12, wobei das Entfernen des Templatmoleküls (T) über Durchführen eines Waschschrittes durchgeführt wird.

14. Verfahren nach einem beliebigen der Ansprüche 7 bis 13, das ferner umfasst:
- Pfropfen eines zweiten molekular geprägten Polymers auf das teilweise umgewandelte konjugierte Polymer (3).

15. Verwendung eines molekular geprägten konjugierten Polymers (MICP) (7) nach einem der Ansprüche 1 bis 6 in Chemo- und Biosensoren.

16. Verwendung eines molekular geprägten konjugierten Polymers (MICP) (7) nach einem der Ansprüche 1 bis 6 in elektronischen Vorrichtungen.

17. Verwendung eines molekular geprägten konjugierten Polymers (MICP) (7) nach einem der Ansprüche 1 bis 6 zur Chromatographie, molekularen Erkennung, selektiven Probenanreicherung oder Katalyse.

18. Chemo- oder Biosensor umfassend ein molekular geprägtes konjugiertes Polymer (MICP) (7), wie in einem beliebigen der Ansprüche 1 bis 6 beansprucht.

19. Elektronische Vorrichtung umfassend ein molekular geprägtes konjugiertes Polymer (MICP) (7) nach einem der Ansprüche 1 bis 6.

## Revendications

1. Polymère conjugué à empreinte moléculaire (MICP) (7) comprenant :
- un squelette de polymère conjugué (7a) et
- au moins un polymère à empreinte moléculaire (7b) greffé sur ledit squelette de polymère conjugué (7a).

2. Polymère conjugué à empreinte moléculaire (MICP) (7) selon la revendication 1 ayant une fonctionnalité de sélectivité et une fonctionnalité de transducteur.

3. Polymère conjugué à empreinte moléculaire (MICP) (7) selon la revendication 1 ou 2, ledit polymère à empreinte moléculaire comprenant des alvéoles (8), dans lequel lesdites alvéoles (8) ont une forme, une taille et des groupes fonctionnels qui dépendent d'une molécule de matrice (T) utilisée pendant la réaction de polymérisation pour la formation du polymère conjugué à empreinte moléculaire (MICP) (7).

4. Polymère conjugué à empreinte moléculaire (MICP) (7) selon l'une quelconque des revendications précédentes, ledit polymère conjugué à empreinte moléculaire (MICP) (7) étant à base de dérivés de poly(p-phénylènevinylène).

5. Polymère conjugué à empreinte moléculaire (MICP) (7) selon l'une quelconque des revendications 1 à 4, ledit polymère conjugué à empreinte moléculaire (MICP) (7) étant à base de OC1C10-PPV.

6. Polymère conjugué à empreinte moléculaire (MICP) (7) selon l'une quelconque des revendications 1 à 5, ledit polymère conjugué à empreinte moléculaire (MICP) (7) étant à base de polymères conjugués qui peuvent contenir une ou plusieurs unités de thiophène ou de fluorène, et/ou peuvent contenir des unités d'arylène, d'hétéroarylène, de vinylène.

7. Procédé de préparation d'un polymère conjugué à empreinte moléculaire (MICP) (7), ledit procédé comprenant :
- la formation d'un polymère conjugué partiellement converti (3), qui est un polymère macro-iniferter conjugué, et
- la greffe d'un premier polymère à empreinte moléculaire (7b) sur ledit polymère macro-iniferter conjugué (3).

8. Procédé selon la revendication 7, dans lequel la formation d'un polymère conjugué partiellement converti (3) qui est polymère macro-iniferter conjugué est effectuée en solution.

9. Procédé selon la revendication 7, dans lequel la formation d'un polymère conjugué partiellement converti (3) qui est polymère macro-iniferter conjugué est effectuée en film mince.

10. Procédé selon l'une quelconque des revendications 7 à 9, dans lequel la formation d'un polymère conjugué partiellement converti (3) qui est un polymère macro-iniferter conjugué comprend :
- la réaction d'une solution de monomères (1) avec un composé basique pour former un polymère précurseur (2), et
- la conversion partielle dudit polymère précurseur (2).

11. Procédé selon l'une quelconque des revendications 7 à 10, dans lequel la greffe d'un premier polymère à empreinte moléculaire (7b) sur ledit polymère conjugué partiellement converti (3), qui est un polymère macro-iniferter conjugué, comprend :
- l'irradiation dudit polymère conjugué partiellement converti (3), qui est un polymère macro-iniferter conjugué, avec une lumière UV, en formant ainsi un radical macro-iniferter conjugué (4), et
- la réaction dudit radical macro-iniferter conjugué (4) avec au moins un premier et un second monomères en présence d'une molécule de matrice (T).

12. Procédé selon la revendication 11, ledit procédé comprenant en outre :
- l'enlèvement de ladite molécule de matrice (T).

13. Procédé selon la revendication 12, dans lequel l'enlèvement de ladite molécule de matrice (T) est réalisé en effectuant une étape de lavage.

14. Procédé selon l'une quelconque des revendications 7 à 13, comprenant en outre :
- la greffe d'un second polymère à empreinte moléculaire sur ledit polymère conjugué partiellement converti (3).

15. Utilisation d'un polymère conjugué à empreinte moléculaire (MICP) (7) comme revendiqué selon l'une quelconque des revendications 1 à 6 dans des chimiocapteurs et des biocapteurs.

16. Utilisation d'un polymère conjugué à empreinte moléculaire (MICP) (7) comme revendiqué selon l'une quelconque des revendications 1 à 6 dans des dispositifs électroniques.

17. Utilisation d'un polymère conjugué à empreinte moléculaire (MICP) (7) comme revendiqué selon l'une quelconque des revendications 1 à 6 en chromatographie, en reconnaissance moléculaire, en enrichissement d'échantillon sélectif ou en catalyse.

18. Chimiocapteur ou biocapteur comprenant un polymère conjugué à empreinte moléculaire (MICP) (7) comme revendiqué selon l'une quelconque des revendications 1 à 6.

19. Dispositif électronique comprenant un polymère conjugué à empreinte moléculaire (MICP) (7) comme revendiqué selon l'une quelconque des revendications 1 à 6.
